# EUROPEAN PATENT APPLICATION

(11) **EP 4 535 402 A1**
(43) Date of publication of application: **09.04.2025**
(21) Application number: 23202146.9
(22) Date of filing: 06.10.2023
(51) Int. Cl.: H01L 21/28, H10B 41/27, H10B 43/27, H01L 29/49, H01L 29/792

(54) **A METHOD FOR FORMING A MEMORY STRUCTURE FOR A 3D NAND FLASH MEMORY**

(71) Applicant: Imec VZW, 3001 Leuven (BE)
(72) Inventor: RACHIDI, Sana, 3000 Leuven (BE); VAN DEN BOSCH, Geert, 3010 Kessel-Lo (BE); ROSMEULEN, Maarten, 9000 Gent (BE); ARMINI, Silvia, 3001 Heverlee (BE)
(74) Representative: Lind Edlund Kenamets Intellectual Property AB

(57) **Abstract**

According to an aspect, there is provided a method for forming a memory structure for a 3D NAND flash memory, the method comprising:
forming a layer stack over a substrate;
forming first recessed areas in a sidewall surrounding a memory hole in the layer stack by laterally etching back gate layers of the layer stack from the memory hole;
forming a lateral memory stack in each first recessed areas, by depositing a blocking oxide and, subsequently, a charge trap material;
forming second recessed areas in the sidewall by laterally etching back the inter-gate spacer layers from the memory hole;
forming dummy layers in the second recessed areas;
lining the sidewall of the memory hole with a liner layer;
subjecting the dummy layers to a thermal treatment process adapted to convert each dummy layer into an air gap structure;
forming a tunneling oxide layer in the memory hole, along the liner layer, and a channel layer along the tunneling oxide layer.

## Description

### TECHNICAL FIELD

The present invention generally relates to a method for forming a memory structure for a 3D NAND flash memory.

### BACKGROUND

The bit density in the 3D NAND flash memory road map increases every year. This far, the increase has been enabled by increasing the number of stacked memory cells along the vertical dimension. However, this route is becoming increasingly difficult and costly. Hence, there is increasing interest in techniques for scaling the cells along the vertical dimension. Vertical scaling ("z-pitch scaling") is achieved by reducing the thickness of the layers in the layer stack, e.g. the word line (gate) layers and oxide inter-gate spacer layers.

Z-scaling however results in a reduced inter-cell separation which in turn leads to an increased parasitic capacitance between the word lines of the cells, thus making it difficult to control the cell-to-cell interference. Increased cell-to-cell interference may degrade the performance related parameters of the memory device, notably decrease the threshold voltage and increase increased the program voltage. There is hence a need for scalable techniques allowing better control over the cell-to-cell interference.

### SUMMARY

As realized by the inventors, an efficient way to control cell-to-cell interference would be to introduce air gap structures between the gate / word line layers. It is therefore an object of the present invention to provide a method for forming a memory structure suitable for a 3D NAND flash memory, allowing forming of air gap structures in the memory structure also at aggressive z-pitch scaling.

Hence, according to an aspect of the present invention, there is provided a method for forming a memory structure for a 3D NAND flash memory, the method comprising:
forming a layer stack over a substrate, the layer stack comprising an alternating sequence of gate layers and inter-gate spacer layers;
forming first recessed areas in a sidewall surrounding a memory hole in the layer stack by laterally etching back the gate layers from the memory hole;
forming a lateral memory stack in each first recessed areas, by depositing a blocking oxide and, subsequently, a charge trap material;
forming second recessed areas in the sidewall by laterally etching back the inter-gate spacer layers from the memory hole;
forming dummy layers in the second recessed areas;
after forming the lateral memory stack and the dummy layers, lining the sidewall of the memory hole with a liner layer;
after lining the sidewall, subjecting the dummy layers to a thermal treatment process adapted to convert each dummy layer into an air gap structure, wherein the air gap structures are formed laterally between the liner layer and the inter-gate spacer layers;
forming a tunneling oxide layer in the memory hole, along the liner layer; and
forming a channel layer along the tunneling oxide layer.

Thus, the method according to the present aspect enables forming of a memory structure comprising discrete lateral memory stacks in each gate / word line layer (or equivalently, for each memory cell), wherein the lateral memory stacks are vertically separated by air gap structures. Due to the low dielectric constant (low k) of an air gap structure, inter-cell interference may hence be efficiently reduced. In particular, an air gap structure has a lower k than oxides suitable for forming the inter-gate spacer layers.

By the term "air gap structure" is herein meant a space or void enclosed by a pair of lateral memory stacks, the liner layer and an inter-gate spacer layer. The space may contain air and/or other ambient gases which may be present in the process environments in which the steps of the method are performed, or traces of non-polymer material (e.g. in solid-phase, forming a porous structure in the second recessed areas) remaining from the converted dummy layers.

A further advantage of the present method aspect is that the air gaps separate the charge trap layer. Traditionally, the charge trap layer has been deposited as a continuous layer along the sidewall of the memory hole in the layer stack. The reduced inter-cell separation entailing z-scaling results in a reduced inter-cell separation which in turn may reduce the retention performance of a continuous charge trap layer. By the present method aspect however, a separate discrete charge trap layer is formed for each gate layer, thereby enabling an improved retention performance of each cell.

The use of a thermal treatment process, allows reliable conversion of the dummy layers into air gap structures (e.g. removing the dummy layers by heating) although the dummy layers are enclosed by the lateral memory stacks, the liner layer and the inter-gate spacer layers. Meanwhile, the liner layer ensures that subsequently deposited materials do not fill the air gap structures.

A possible challenge introduced by the presence of dummy layers in the layer stack, is that materials which may be converted into air gap structures (e.g. polymers) may have poor compatibility with other materials of the layer stack. For instance, dummy materials suitable for the thermal treatment process may introduce mechanical stress into the layer stack, or reduce adhesion between the stacked layers. As the inter-gate space layers according to the present method aspect are partially preserved in the layer stack (i.e. implying that the dummy layers and thus the air gap structures are locally introduced between the lateral memory stacks), there is however a reduced risk of the dummy layers introducing structural defects into the layer stack. Consider as an illustrative comparative example, a hypothetical process comprising completely replacing the inter-gate space layers by dummy layers, wherein the risk of deformation or delamination of the layer stack would be considerably greater than in the present method aspect.

Moreover, by forming the air gap structure prior to the channel layer, the thermal budget for the channel layer formation may be selected without considering the risk of inadvertently affecting the dummy layers (e.g. the thermal budget for poly-Si deposition may exceed the decomposition temperature for many suitable polymer dummy materials).

Reference is herein made to "first recessed areas" and "second recessed areas". It is to be noted that "first" and "second" here are mere labels, and do not imply any particular temporal order of forming the respective recessed areas. That is, as will become apparent from the following disclosure, in some embodiments the "first" recessed areas may be formed prior to the "second" recessed areas, and in some embodiments the "second" recessed areas may be formed prior to the "first" recessed areas.

In some embodiments, the dummy layers are formed of a polymer-comprising material. There exists many polymers that may be efficiently and reliably removed using a thermal treatment process, e.g. by evaporation, leaving substantially no organic residues in the layer stack (although non-polymer traces may remain, as discussed below).

In some embodiments the treatment process removes the polymer-comprising material of the dummy layers from the second recessed areas.

Optionally, trace amounts of dummy material (e.g. decomposed dummy material) may remain in the second recessed areas to form the air gap structures, such as a silicate compound.

In some embodiments, the liner layer is deposited at a temperature below a temperature causing conversion of the dummy layers into the air gap structures. Accidental conversion of the dummy layers before the second recessed areas are "sealed off' by the liner layer may thus be avoided.

In some embodiments, the liner layer is formed of a low thermal oxide (LTO). A low thermal oxide (e.g. LTO SiO₂) may be reliably deposited without triggering conversion of the dummy layers.

In some embodiments, a thickness of the liner layer is in a range of 1-4 nm, or 1-2 nm.

In some embodiments, a lateral depth of the second recessed areas is such that the air gap structures undercut at least the charge trap material of the lateral memory stacks. The air gap structures may thus be formed at the locations where they have the greatest impact on cell-to-cell interference, namely between the charge trap material.

In some embodiments, the lateral depth of the second recessed areas is such that the air gap structures further undercut the blocking oxide of the lateral memory stacks. The air gap structures may thus extend laterally along the full (lateral) thickness dimension of the lateral memory stack, further reducing inter-cell interference.

In some embodiments, the gate layers are sacrificial gate layers and the method further comprises, subsequent to forming the air gap structures, replacing the sacrificial gate layers by a replacement metal gate stack. The sacrificial gate layers may be removed by etching back the sacrificial gate layers from a second hole in the layer stack, different from the memory hole, and subsequently forming a replacement metal gate stack replacing the sacrificial gate layers.

In some embodiments, a lateral depth of the second recessed areas is such that the air gap structures undercut the charge trap material of the lateral memory stacks but do not undercut the blocking oxide of the lateral memory stacks. The air gap structures may thus be protected during the replacement metal gate stack deposition.

In some embodiments, the method further comprises depositing a further liner layer of a dielectric material in the second recessed areas prior to forming the dummy layers, wherein the further liner layer is used as an etch stop layer when replacing the sacrificial gate layers by the replacement metal gate stack. The air gap structures may thus be protected during the replacement metal gate stack deposition, even if the second recessed areas undercut also the blocking oxide.

In some embodiments, the second recessed areas are formed after forming the lateral memory stacks in the first recessed areas. A risk of the deposition of the blocking oxide and charge trap material depositions causing accidental conversion of the dummy layers before the second recessed areas are "sealed off' by the liner layer may thus be avoided.

In some embodiments, the method further comprises, prior to forming the first recessed areas:
forming initial recessed areas in the sidewall surrounding the memory hole by laterally etching back the inter-gate spacer layers from the memory hole; and
forming sacrificial layers in the initial recessed areas;
wherein the first recessed areas are formed after forming the sacrificial layers, and wherein the lateral memory stacks are formed by selectively depositing, in the first recessed areas, the blocking oxide and, subsequently, the charge trap material, wherein the sacrificial layers define deposition-inhibiting areas for the selective deposition of the blocking oxide and the charge trap material.

Accordingly, rather than depositing a continuous charge trap layer and subsequently "cutting" the charge trap layer into a number of discrete portions by etching, the method "directly" deposits the discrete charge trap layers using an area selective deposition process (ASD), wherein the sacrificial layers are used to define deposition-inhibiting areas ("non-growth areas"). Deposition of the charge trap material in areas vertically between the gate layers may hence be avoided, thus obviating the need for cutting the charge trap material by etching. By obviating the need for etching, the thickness dimension of the charge trap layers (as seen along the lateral dimension) may be precisely controlled by maintaining the growth conditions of the selective deposition until a target thickness has been achieved. The preceding discussion applies correspondingly to the blocking oxide.

Since the inter-gate spacer layers are formed of a dielectric material (typically an oxide) it is envisaged that depositing the blocking oxide and the charge trap material selectively in the first recessed areas (i.e. in vertical levels of the gate layers) without any appreciable concurrent deposition on the inter-gate spacer layers would be challenging. However, by etching back the inter-gate spacer layers to form the initial recessed areas in the sidewall and then forming sacrificial layers in the initial recessed areas (e.g. filling the initial recessed areas with sacrificial layer material), a considerably improved area selectivity may be achieved. That is, the sacrificial layer material may be selected to facilitate the area selective deposition without regard to its suitability in a finished functional memory device. In general, the sacrificial layers may be formed of a sacrificial layer material selected to be deposition-inhibiting for the selective deposition of the blocking oxide.

A further advantage of the deposition-inhibiting properties of the sacrificial layers is that the risk for pinch-off of the first recessed areas by either the blocking oxide or charge trap material deposition may be avoided.

In some embodiments, the initial recessed areas are the second recessed areas and the method further comprises, after forming the lateral memory stacks, removing the sacrificial layers from the second recessed areas by etching from the memory hole and thereafter forming the dummy layers in the second recessed areas.

Hence, a re-growth of the inter-gate spacer layers in the initial recessed areas and subsequent lateral etch back thereof to form the second recessed areas may in this approach be omitted. The sacrificial layers may thus, in addition to their deposition-inhibiting function while forming the lateral memory stacks, act as a place-holder for the dummy layers, and thus be replaced by the dummy layers after forming the lateral memory stacks. In this approach, the sacrificial layer material may further be selected to be etchable selectively to the charge trap material, the blocking oxide and the material of the gate layer (i.e. the sacrificial layer material may be etched at a greater rate than each of the charge trap material, the blocking oxide and the material of the gate layer) so as to allow a selective removal of the sacrificial layers from the initial/second recessed areas.

Alternatively, in some embodiments, the method further comprises, after forming the lateral memory stacks:
removing the sacrificial layers by etching from the memory hole;
after removing the sacrificial layers, re-growing the inter-gate spacer layers such that the lateral memory stacks are vertically separated by the re-grown inter-gate spacer layers;
and wherein after re-growing the inter-gate spacer layers, the method proceeds by forming the second recessed areas by laterally etching back the re-grown inter-gate spacer layers.

Thereby, the materials of the sacrificial layers and the dummy layers may be selected independently from one another (e.g. to separately optimize the deposition-inhibiting properties of the sacrificial layers and the conversion of the dummy layers into air gap structures), and to form the initial recessed areas and the second recessed areas with respective depths, chosen independently from one another. In this approach, the sacrificial layer material may further be selected to be etchable selectively to the charge trap material, the blocking oxide and the material of the gate layer (i.e. the sacrificial layer material may be etched at a greater rate than each of the charge trap material, the blocking oxide and the material of the gate layer) so as to allow a selective removal of the sacrificial layers from the initial recessed areas. In some embodiments, the sacrificial layers are metal oxide-layers, such as Al₂O₃ or TiO₂ layers, metal-nitride layers, such as AlN or TiN layers, metal layers, such as Co, Ru, Cu, W or Mo layers, or carbon-comprising layers, such as amorphous carbon or organic spin-on layers. Sacrificial materials of any of these types facilitates process control as they tend to define deposition-inhibiting surfaces with respect to ASD of the blocking oxide and the charge trap material. These sacrificial materials further enable etch selectivity with respect to the charge trap material, the blocking oxide and the material of the gate layer (be it polysilicon or a nitride-comprising material). This applies in particular to carbon-comprising layers, such as amorphous carbon or organic spin-on layers.

Alternatively, in some embodiments, the initial recessed areas are the second recessed areas and the sacrificial layers are the dummy layers. The dummy layers (e.g. formed of a polymer-comprising material) may thus both be used as a deposition-inhibiting layer to facilitate ASD of the blocking oxide and the charge trap material, and subsequently be converted into air gap structures by the thermal treatment process.

### BRIEF DESCRIPTION OF THE DRAWINGS

This and other aspects of the present invention will now be described in more detail, with reference to the appended drawings showing embodiments of the present invention.
Fig. 1a-b schematically shows a schematic cross-sectional view, and a top-down view, respectively, of a starting structure for forming a memory structure according to an embodiment.
Fig. 2 shows the structure after forming first recessed areas.
Fig. 3 shows the structure after forming lateral memory stacks in the first recessed areas.
Fig. 4 shows the structure after forming second recessed areas.
Fig. 5-6 shows forming of dummy layers in the second recessed areas.
Fig. 7 shows the structure after lining the sidewall of the memory hole.
Fig. 8 shows the structure after converting the dummy layers into air gap structures.
Fig. 9 shows the structure after forming a tunnelling oxide layer and a channel layer.
Fig. 10 shows a structure after forming a dielectric liner in first recessed areas, prior to depositing a blocking oxide, according to a further embodiment.
Fig. 11 shows a lateral memory stack formed according to Fig. 10.
Fig. 12 shows a lateral memory stack formed according to a further embodiment.
Fig. 13-16 shows a sequence of optional process steps facilitating selective deposition of blocking oxide and charge trap material.

### DETAILED DESCRIPTION

Embodiments of methods for forming a memory structure for a 3D NAND flash memory, such as a 3D-Gate-All-Around-NAND (3D GAA NAND), will now be described with reference to the drawings. The drawings are only schematic and that the relative dimensions of some structures and layers may be exaggerated and not drawn on scale. Rather the dimensions may be adapted for illustrational clarity and to facilitate understanding of the following description. When present in the figures, the indicated axes X, Y and Z consistently refer to a first horizontal or lateral direction, a second horizontal or lateral direction, and a vertical direction, respectively. As used herein, the terms "horizontal" and "lateral" refer to directions parallel to a supporting substrate of the memory structure. The term "vertical" refers to a direction parallel to a normal direction of the substrate, i.e. transverse to the substrate.

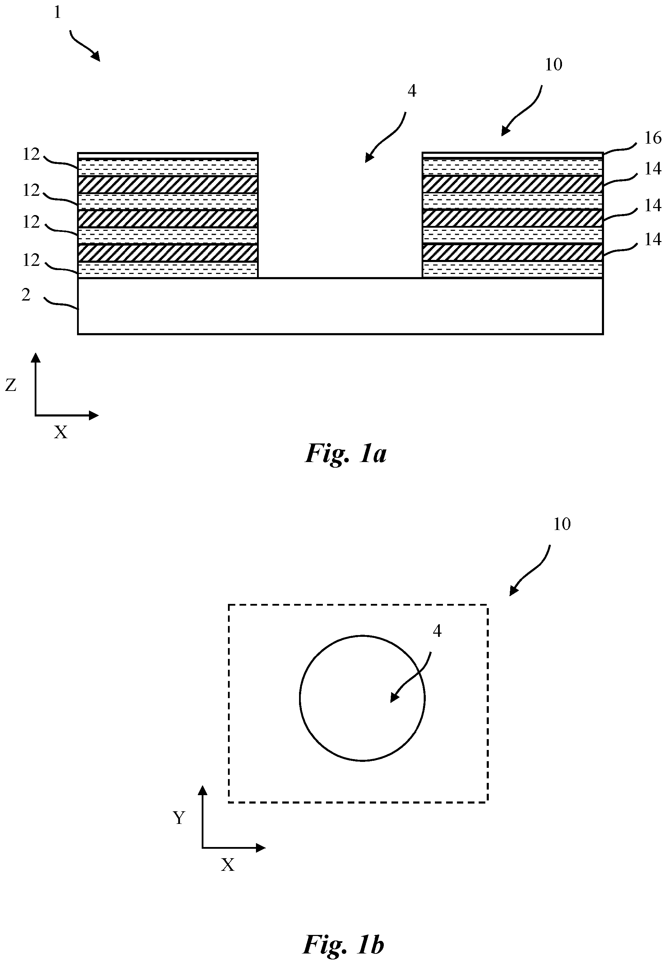

Fig. 1a-b schematically shows a schematic cross-sectional view, and a top-down view, respectively, of a structure 1 at an initial stage of the method. The structure 1 comprises a layer stack 10 representing a precursor or starting structure for the memory structure, to be subjected to the processing steps of the method disclosed in the following.

The layer stack 10 is formed over a substrate 2 and comprises an alternating sequence of gate layers 14 and inter-gate spacer layers 12.

The substrate 2 may be a conventional substrate, suitable for semiconductor processing and for supporting a memory structure for a 3D NAND flash memory. The substrate 2 may for instance be a Si substrate, a Ge substrate or a SiGe substrate. Other examples include a silicon-on-insulator (SOI) substrate, a GeOI substrate or a SiGeOI substrate.

The gate layers 14 may be nitride-comprising layers, such as SiN layers, thus forming sacrificial gate layers 14 intended to be replaced by an RMG stack in subsequent process steps. The gate layers 14 may also be functional gate layers, e.g. highly doped polysilicon-comprising layers.

The inter-gate spacer layers 12 may be oxide-comprising layers, such as SiO₂ layers or another suitable inter-layer dielectric (e.g. of low-k). The inter-gate spacer layers 12 are arranged in the layer stack 10 to provide vertical separation between the memory cells / word lines of the memory device which is to be formed.

The layer stack 10 may be formed by interchangeably depositing layers of gate material (e.g. nitride) and inter-gate spacer material (e.g. oxide) using deposition processes which per se are known in the art, such as chemical vapor deposition (CVD), physical vapor deposition (PVD) or atomic layer deposition (ALD).

The inter-gate spacer layer 12 and the gate layers 14 may be formed in numbers in accordance with the intended number of stacked memory cells of the memory device. It is to be noted that the number of layers 12, 14 of the illustrated layer stack 10 merely is a non-limiting example and that the method disclosed herein is compatible with stacks of memory cells of essentially any number currently used, or contemplated, in the industry, such as 64, 128, 256 or greater.

The inter-gate spacer layers 12 and the gate layers 14 may be formed with a respective layer thickness in a range of 5-25 nm, as an example. A z-pitch of the layer stack 10 (i.e. the combined thickness of one inter-gate spacer layer and one gate layer 14) may be in a range from about 45 nm to 15 nm or less.

The layer stack 10 may as shown further comprise a capping layer in the form of a semiconductor layer 16, deposited on top of the top-most inter-gate spacer layer 12. The semiconductor layer 16 may for instance be formed of Si.

After depositing the layers 12 and 14 (and optionally 16) of the layer stack 10, a memory hole 4 may be patterned in the layer stack 14, e.g. by a lithography and etching process. While Fig. 1a-b shows a portion of the layer stack 10 surrounding a single memory hole 4, it is noted that a corresponding memory hole 4 may be patterned at each location where a respective vertical string of memory cells is desired. The memory hole 4 may as shown be formed to extend through each one of the inter-gate spacer layers 12 and gate layers 14 of the layer stack 10. The memory hole 4 may as further shown in the top-down view of Fig. 1b be formed with a circular cross-sectional shape, such that the memory hole 4 may be formed with a substantially circular cylindrical shape. However, the memory hole 4 may also be formed with other cross-sectional shapes, such as an oval or polygonal shape.

While not shown in Fig. 1a, the layer stack 10 may as per se is known in the art further comprise, underneath the layers 12, 14, a sub-stack of a select layer and a source layer for forming a select plate and a source plate, respectively, of the memory device. The select and source layers may hence form a bottom sub-stack of the layer stack 10. The select and source layers may be formed by conventional techniques and materials, e.g. doped semiconductor layers (e.g. polysilicon), and be separated by layers of interlayer dielectric.

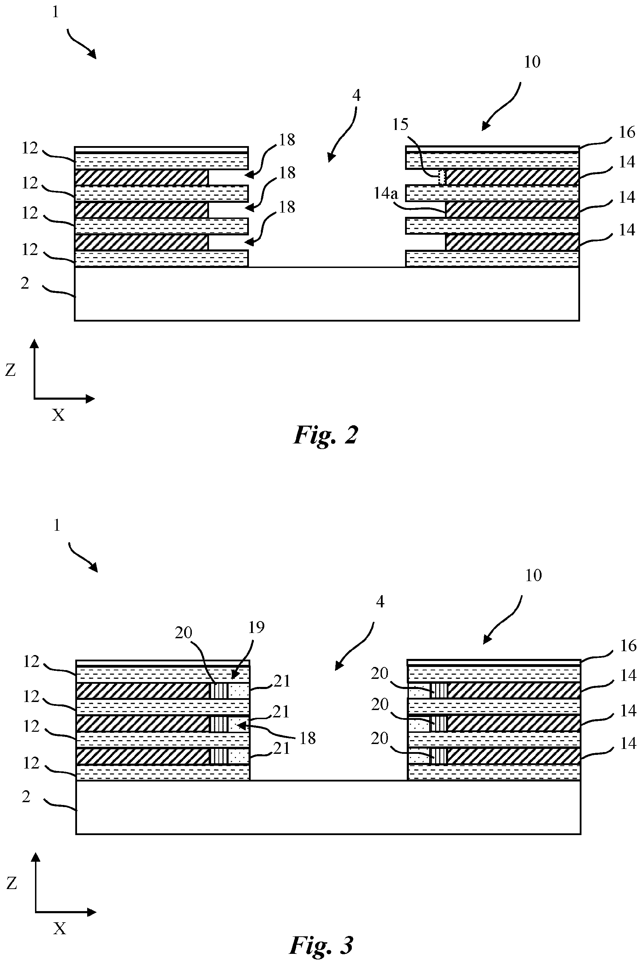

In Fig. 2, first recessed areas 18 have been formed in the sidewall surrounding the memory hole 4 by laterally etching back the gate layers 14 relative the inter-gate spacer layers 12 from the memory hole 4.

The gate layers 14 are laterally etched back (along the X-axis) selectively to the inter-gate spacer layers 12 such that the first recessed areas 18 are formed between the inter-gate spacer layers 12. That is, each recessed area / recess of the first recessed areas 18 is formed between a pair of inter-gate spacer layers 12. Due to the circumferential extension of the sidewall about the memory hole 4, the first recessed areas 18 may extend circumferentially about the memory hole 4. In the example of a circular memory hole 4, the first recessed areas 18 may be annular.

The gate layers 14 may be etched back using an etching process adapted to etch the gate layers 14 selectively to the inter-gate spacer layers 12. That is, the etching process may be adapted to etch (i.e. remove) the material (e.g. the nitride material) of the gate layers 14 selectively to the material (e.g. the oxide material) of the inter-gate spacer layers 12, e.g. such that the gate layers 14 may be laterally etched back without causing any substantial etch-back of the inter-gate spacer layers 12. The etching process may be applied to the sidewall of the layer stack 10 via the memory hole 4. Any suitably selective etching process, wet or dry, providing a sufficient lateral etching component with respect to the gate layers 14 (such as an isotropic etching process) may be used.

The first recessed areas 18 may be formed with a depth (along the X-axis) matching an intended lateral thickness of the lateral memory stacks 19 to be formed at the levels of the gate layers 14 (see e.g. Fig. 3 discussed below). The depth (i.e. the amount of lateral etch back) of the first recessed areas 18 may for example be in a range of 6-20 nm. The depth of the first recessed areas 18 may be controlled by timing the lateral etch back.

Fig. 3 depict the structure after forming a lateral memory stack 19 in each first recessed area 18 by depositing, in the first recessed areas 18, a blocking oxide 20 and, subsequently, a charge trap material 21.

Each lateral memory stacks 19 forms, as shown, a discrete lateral memory stack 19 in a respective recessed area 18, each comprising a discrete blocking oxide portion or layer (which in the following also may be referred to using reference sign 20) and a discrete charge trap material portion or layer (which in the following also may be referred to using reference sign 21).

The blocking oxide 20 may be formed with a lateral thickness (along the X-axis) in a range of 4-12 nm. The charge trap material (layers) 21 may be formed with a lateral thickness (along the X-axis) in a range of 4-8 nm. More generally, the blocking oxide 20 and the charge trap material 21 may fill the first recessed areas 18 such that the inner end surfaces of the charge trap material (layers) 21 (i.e. facing inwardly with respect to the memory hole 4) are substantially flush with the inner end surfaces of the inter-gate spacer layers 12. The lateral memory stacks 19 may thus fill the lateral depth of the first recessed areas 18, thereby restoring the sidewall surrounding the memory hole 4 to a substantially straight profile.

The blocking oxide 24 may comprise or be SiOₓ (e.g. SiO₂), or some other oxide material suitable to be used as a blocking oxide. The charge trap material 26 may comprise or be SiN (i.e. Si₃N₄), or some other oxide material suitable to be used as a charge trap material.

The lateral memory stacks 19 may be formed using both area-selective and non-area-selective deposition techniques.

Using a non-area selective deposition technique, the forming of the lateral memory stacks 19 may comprise conformally depositing (e.g. using ALD) an initial blocking oxide layer in each first recessed area 18 and to cover the sidewall of the memory hole 4, e.g. including the inner end surfaces of the inter-gate spacer layers 12. The initial blocking oxide layer may subsequently be laterally etched back (e.g. using an isotropic etch) such that the inner end surfaces of the inter-gate spacer layers 12 at the sidewall of the memory hole 4 are exposed and discrete portions of the blocking oxide remain in the first recessed areas 12. Subsequently, an initial charge trap material layer may be conformally deposited (e.g. using ALD) in a corresponding fashion in each first recessed area 18 (e.g. on the blocking oxide 20) and to cover the sidewall of the memory hole 4, e.g. including the inner end surfaces of the inter-gate spacer layers 12. The initial charge trap material layer may subsequently be laterally etched back (e.g. using an isotropic etch) such that the inner end surfaces of the inter-gate spacer layers 12 at the sidewall of the memory hole 4 are exposed and discrete portions of the charge trap material 21 remain in the first recessed areas 12, e.g. on the blocking oxide 20.

Using an area-selective deposition technique, the lateral memory stacks 19 may be formed by selectively depositing, in the first recessed areas 18, the blocking oxide 20 and, subsequently, the charge trap material 21. Hence, both the blocking oxide 20 and the charge trap material 21 are selectively deposited, wherein the inter-gate spacer layers 12 define deposition-inhibiting areas (non-growth areas) for the selective deposition of the blocking oxide 20 and the charge trap material 21. As the blocking oxide 20 and the charge trap material 21 are selectively deposited in the first recessed areas 18, the blocking oxide 20 may be directly deposited to define a discrete blocking oxide layer in each first recessed area 18 and the charge trap material 21 may be directly deposited to form a discrete charge trap layer in each first recessed area 18. The blocking oxide 20 may be deposited using any deposition process (e.g. an ALD or CVD process) allowing area-selective deposition of the blocking oxide 20 (e.g. SiO₂) such that the blocking oxide 20 is deposited on growth-promoting or seeding surface portions in the first recessed areas 18 but not on the growth-inhibiting areas of the inter-gate spacer layers 12. The growth-promoting surface portions may in particular be defined by the surface portions (i.e. the end surfaces 14a indicated in Fig. 2) of the etched back gate layers 14 exposed in the first recessed areas 18. The charge trap material 21 may be deposited using any deposition process (e.g. an ALD or CVD process) allowing area-selective deposition of the charge trap material 21 (e.g. SiN) such that the charge trap material 21 is deposited on growth-promoting or seeding surface portions in the first recessed areas 18 but not on the growth-inhibiting areas of the inter-gate spacer layers 12. The growth-promoting surface portions may in particular be defined by the already deposited blocking oxide 20.

To facilitate a selective deposition of the blocking oxide 20, the layer stack 10 may be subjected to a treatment step prior to depositing the blocking oxide 20, adapted to functionalize the surface portions / end surfaces 14a of the etched back gate layers 14 in the first recessed areas 18 and thereafter depositing the blocking oxide 20 on the functionalized surface portions in the first recessed areas 18. For instance, as schematically indicated in one of the recessed areas 18 of Fig. 2, the functionalization may comprise depositing a deposition-promoting layer 15 on the surface portions 14a of the etched back gate layers 14 in the first recessed areas 18. Additionally or alternatively, the layer stack 10 may be subjected to a treatment process adapted to passivate exposed surface portions of the inter-gate spacer layers 12 with respect to the selective deposition of the blocking oxide 20 and the charge trap material 21. For instance, as per se is known in the art, some deposition processes favor deposition on hydrogen terminated surfaces (e.g. the deposition process deposits material preferentially on hydrogen terminated surfaces). A treatment process may hence be adapted to increase an occurrence of hydrogen terminated bonds on the gate layers 14 (thus promoting deposition thereon) and/or reduce an occurrence of hydrogen terminated bonds on the itnergate spacer layers 12 (thus inhibiting deposition thereon). This is however merely one non-limiting example and other techniques are known to the skilled person.

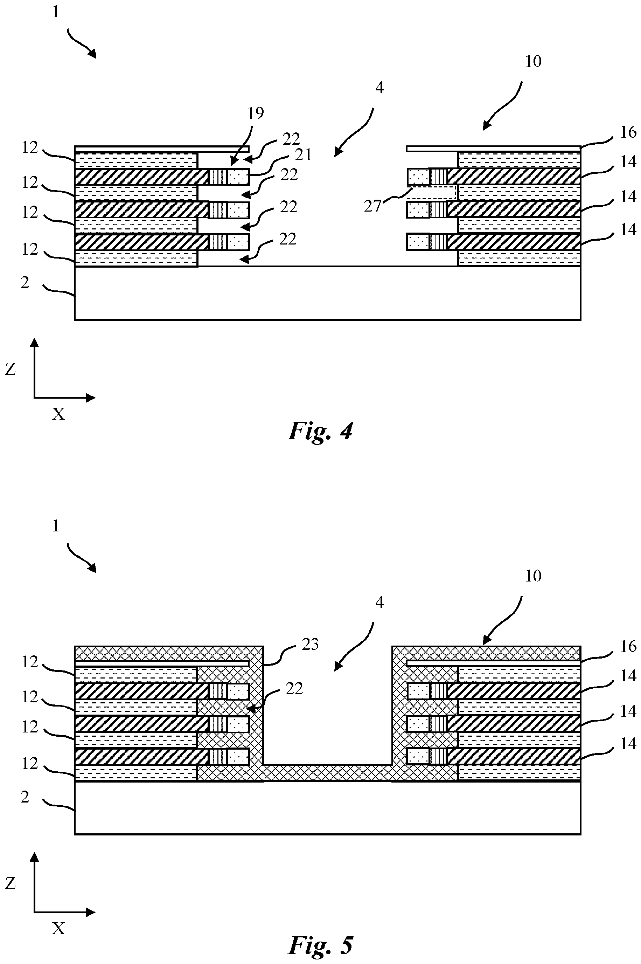

In Fig. 4, second recessed areas 22 have been formed in the sidewall of the layer stack 10 surrounding the memory hole 4 by laterally etching back the inter-gate spacer layers 12 relative the lateral memory stacks 19 (e.g. the charge trap material 21) from the memory hole 4. The inter-gate spacer layers 12 are laterally etched back (along the X-axis) selectively to the charge trap material 21 such that the second recessed areas 22 are formed between the lateral memory stacks 19. That is, each recessed area / recess of the second recessed areas 22 is formed between a pair of lateral memory stacks 19. Due to the circumferential extension of the sidewall about the memory hole 4, the second recessed areas 22 may extend circumferentially about the memory hole 4. In the example of a circular memory hole 4, the second recessed areas 22 may be annular.

The inter-gate spacer layers 12 may be etched back using an etching process adapted to etch the inter-gate spacer layers 12 selectively to the charge trap material 21. That is, the etching process may be adapted to etch (i.e. remove) the material (e.g. the oxide material) of the inter-gate spacer layers 12 selectively to the material (e.g. the SiN) of the charge trap material 21, e.g. such that the inter-gate spacer layers 12 may be laterally etched back without causing any substantial etch-back of the charge trap material 21. The etching process may be applied to the sidewall of the layer stack 10 via the memory hole 4. Any suitably selective etching process, wet or dry, providing a sufficient lateral etching component with respect to the inter-gate spacer layers 12 (such as an isotropic etching process) may be used.

Providing a semiconductor layer 16 as a top layer of the layer stack 10, ensures that also the top-most inter-gate spacer layer 12 may be recessed. That is, the semiconductor layer 16 may act as an etch mask for top-most inter-gate spacer layer 12 so as to counteract a vertical etch back thereof during the lateral etch-back.

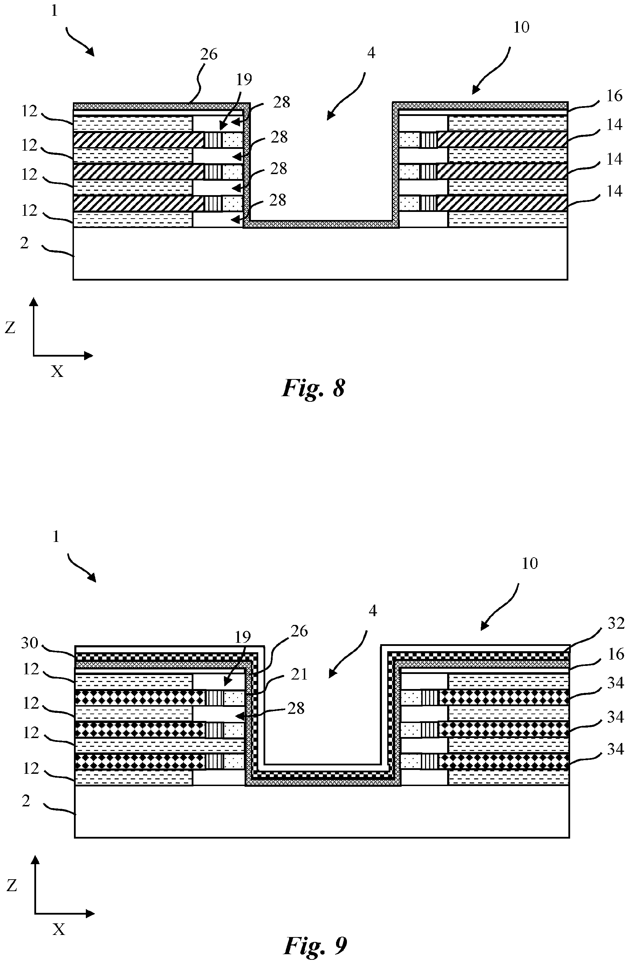

The second recessed areas 22 may be formed with a depth (along the X-axis) to undercut at least the charge trap material 21. This enables the air gap structures 28 which are to be formed (see e.g. Fig. 8 discussed below) to undercut at least the charge trap material 21. The extent of the undercut may be partial or complete with respect to the lateral thickness of the charge trap material. A complete undercut may be advantageous over a partial undercut in that inter-cell interference may be more efficiently reduced. The second recessed areas 22 may as shown in Fig. 4 be formed with a depth to further undercut the blocking oxide 20 of the lateral memory stacks 19. This enables the air gap structures 28 to undercut also the blocking oxide 20, in particular the full lateral thickness / depth of the lateral memory stacks 21. The depth (i.e. the amount of lateral etch back) of the second recessed areas 22 may for example be in a range of 4-40 nm. The depth of the recessed areas 22 may be controlled by timing the lateral etch back.

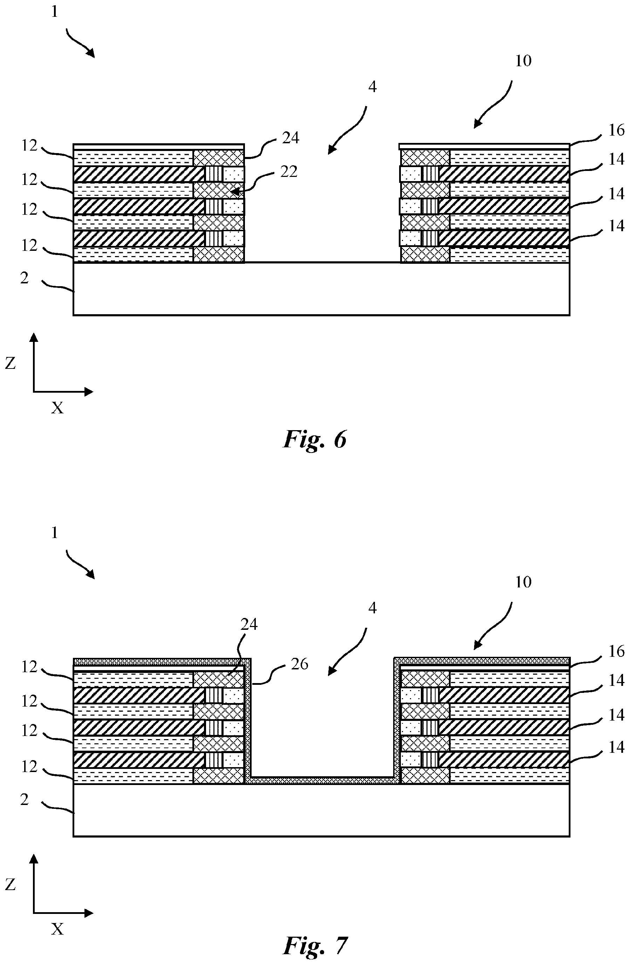

Fig. 5-6 show process steps for forming dummy layers 24 in the second recessed areas 22. In Fig. 5 an initial dummy layer 23 has been conformally deposited (e.g. using ALD) to fill the second recessed areas 24. The initial dummy layer 23 may for instance be deposited with a thickness such that the initial dummy layer 24 closes or "pinches-off" of the second recessed areas 22. Due to the conformal nature of the deposition, the initial dummy layer 23 further covers the sidewall of the memory hole 4, e.g. including the inner end surfaces of the charge trap material 21. In Fig. 6 the initial dummy layer 23 has been laterally etched back (e.g. using an isotropic etch) such that the inner end surfaces of the charge trap material 21 at the sidewall of the memory hole 4 are exposed and discrete dummy layers 24 remain in the second recessed areas 22. As an alternative to a conformal ALD-based deposition of the initial dummy layer 23, an initial dummy layer may also be deposited non-conformally using spin-coating such that the dummy material may enter and fill the second recessed areas 22. The spin-coated initial dummy layer may subsequently be patterned (e.g. using lithography and etching) using an anisotropic etch oriented top-down (opposite the direction of the Z-axis) to remove dummy material deposited on horizontally oriented surfaces of the structure 1 while dummy material within the second recessed areas 22 may masked and thus remain to form the dummy layers 24. In any case, as shown in Fig. 6, the sidewall surrounding the memory hole 4 may be restored to a substantially straight profile.

The dummy layers 24 define temporary place holders for the air gap structures 28 which later are to be formed. The dummy layers 28 are formed of a dummy material selected so as to convertible into air gap structures 28 by a thermal treatment process. Example materials for the dummy layers 18 include polymer-comprising materials, such as a tetracyclododecene (TD)-based sacrificial polymer, polycycloolefin polymers (such as polynorbornene polymers), or some other conventional thermally degradable polymer which may be deposited to fill the second recessed areas 22.

Fig. 7 shows the structure 1 after lining the sidewall of the memory hole 4 with a liner layer 26. The liner layer 26 is conformally deposited (e.g. using ALD) to cover the sidewall of the memory hole 4, and thus cover the inner end surfaces of the dummy layers 24. After depositing the liner layer 26, the dummy layers 24 are hence sealed off from the memory hole 4. Each dummy layer 24 is more specifically surrounded / sandwiched between the liner layer 26 and a respective inter-gate spacer layer 12.

The liner layer 26 is deposited with a thickness so as to allow the decomposed components (e.g. vapor-phase components) of the dummy layers 24, formed when the dummy layers 24 are converted into air gap structures 28 during the subsequent thermal treatment process, to exit the (i.e. diffuse) through the liner layer 26. The liner layer 26 may be formed with a thickness in a range of 1-4 nm, or 1-2 nm. The liner layer 26 may be a low thermal oxide (LTO), such as LTO SiO₂. By depositing the liner layer 26 at a thermal budget with a sufficient margin towards the conversion temperature of the dummy material of the dummy layers 24, premature conversion of the dummy layers 24 may be avoided. For example, for any of the above examples of dummy materials, a deposition temperature of the liner layer 26 at 300 °C or lower may typically provide a sufficient margin.

Fig. 8 shows the structure 1 after converting the dummy layers 24 into air gap structures 28. The conversion is achieved by subjecting the dummy layers 24 to a thermal treatment process adapted to convert the dummy material (e.g. polymer) of each dummy layers 24 into an air gap structure 28. Each air gap structure 28 is formed laterally between the liner layer 26 and a respective inter-gate spacer layer 12. The lateral memory stacks 19 are thus vertically separated by the air gap structures 28. The treatment process may be performed by performing a thermal anneal (e.g. in a reactor chamber or furnace). The thermal energy needed to achieve a sufficient conversion ratio is, as would be understood by the skilled person, dependent on the specific dummy material of the dummy layers 24. For example, for any of the above examples of dummy materials, heating the structure 1 or an ambient of the structure to about 500 °C will typically be sufficient to completely convert the dummy layers 24 without any appreciable formation of residues in the resulting air gaps 28.

It is further contemplated that the dummy material may include components or additives which during the thermal treatment process are converted to, or remain to, form low k sparse matrix or porous air gap structures 28 (organic or non-organic), e.g. of silicate compounds such as (low k) organo silicate (SiOC) or fluorinated silicate (SiOF). The air gap structures 28 are hence not limited to a void spanning the full volume previously occupied by the dummy material, but may also include a low k sparse structures surrounded by air, or including pores with air. However, even in the case of a remaining spares structure, at least a majority portion of the volume spanned by the air gap structure 28 will typically be filled with air.

The lateral depth or extent (along the X-axis) of the air gap structures 28 is determined by the lateral thickness or extent (along the X-axis) of the dummy layers 24, and accordingly of the lateral depth or extent of the second recessed areas 22. This applies correspondingly to the degree the air gap structures 28 will undercut the lateral memory stacks 19. In the illustrated example the air gap structures 28 undercut lateral memory stacks 19 along their full lateral thickness, i.e. both the blocking oxide 20 and the charge trap material 21. However, by forming the second recessed structures 22 to only undercut the charge trap material 21, the air gap structures 28 will not undercut the blocking oxide 20.

In Fig. 9, a tunneling oxide layer 30, and subsequently a channel layer 32, have been formed in the memory hole 4, along the sidewall thereof. The tunneling oxide layer 30 is thus formed along the liner layer 26 and the channel layer 32 is formed along the tunneling oxide layer 30. The tunneling oxide layer 30 and the channel layer 32 may be each be conformally deposited, e.g. using a respective ALD process.

The tunneling oxide layer 30 may be formed of any material conventionally used in the industry for tunneling oxide layers, one non-limiting example being SiON. The channel layer 32 may similarly be formed by any suitable channel material conventionally used in the industry for channel layers, typically a semiconductor material such as Si, SiGe or Ge. While not shown in Fig. 9, the channel layer 32 may present an extension outside of the illustrated portion of the structure 1, to facilitate connection to peripheral semiconductor devices and circuitry, such as select transistors, as per se is known to the skilled person.

If the gate layers 14 are sacrificial gate layers, the method may as shown in Fig. 9 proceed with replacing the sacrificial gate layers 14 by a replacement metal gate stack 34. The sacrificial gate layers 14 may be removed by etching back the sacrificial gate layers 14 from a second hole (not shown) in the layer stack 10 (e.g. denoting the memory hole 4 as a front side hole or opening the second hole may be referred to as a backside hole or opening). The thusly formed lateral cavities formed at the levels of the sacrificial gate layers 14 may subsequently be filled with a replacement metal gate stack replacing the sacrificial gate layers 14. Replacement metal gate stack deposition may as per se is known in the art comprise depositing one or more conductive layers, e.g. a metal such as one or more of TiN and W. The deposition of the conductive layer(s) may be preceded by deposition of a (conformal) high-k gate dielectric.

Provided the lateral depth of the second recessed areas 22 is such that the second recessed areas 22 undercut the charge trap material 21 (completely or partially) but not undercut the blocking oxide 20, the air gap structures 28 may thus be sealed or closed from the gate cavities formed by removing the sacrificial gate layers 14. A risk of the RMG resulting in metal gate stack deposition in the air gap structures 28 may thus be mitigated.

If the second recessed areas 22 are formed to undercut also the blocking oxide 20, the air gap structures 28 may be sealed off during the RMG by, prior to forming the dummy layers 24, depositing a further liner layer 27 (as indicated by the dashed layer 27 in one of the second recessed areas 21 of Fig. 4) of a dielectric material in the second recessed areas 22 prior to forming the dummy layers 24. The further liner layer 27 may be conformally deposited (e.g. by ALD) and laterally etched back or patterned together with the initial dummy layer 23, and thus be removed from the inner end surfaces of the charge trap material 21. The further liner layer 27 may subsequently be used as an etch stop layer when removing the sacrificial gate layers 14 to be replaced by the replacement metal gate stack.

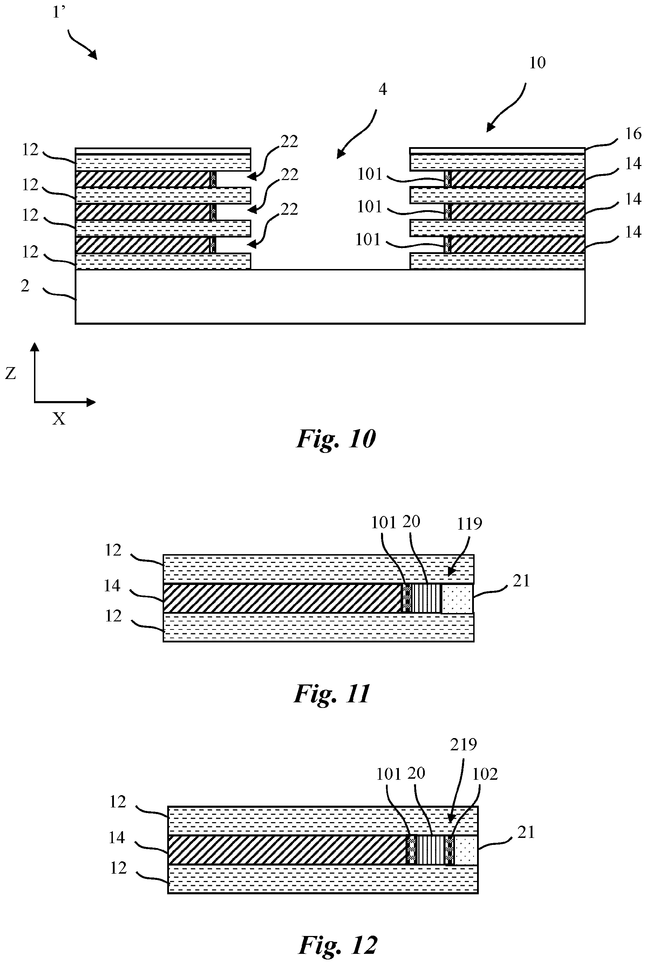

Fig. 10 shows a variation of the preceding process flow, wherein after etching back the gate layers 14 and prior to depositing the blocking oxide 20, a dielectric liner 101is formed in the second recessed areas 22. The dielectric liner 101 may be high-k dielectric (e.g. Al₂O₃ or HfO₂), wherein the liner 101 may define the gate dielectric. In addition to this function, the dielectric liner 101 may, in the case of an RMG process, be used as an etch stop layer (e.g. together with the further liner layer 27 mentioned above) when removing the sacrificial gate layers 14 during the RMG, thereby masking the lateral memory stack 19 from the etching chemistries used when removing the sacrificial gate layers 14.

The dielectric liner 101 may, like the blocking oxide 20, be selectively deposited in the first recessed areas 18, i.e. using a deposition process allowing the liner material of the dielectric liner 101 to deposit selectively on growth-promoting or seeding surface portions in the first recessed areas 18 but not on the growth-inhibiting areas defined by the inter-gate spacer layers 12. The deposition of the dielectric liner 101 may be preceded by one or more treatment processes for functionalization and/or inhibition of the gate layers 14 and inter-gate spacer layers 12, respectively, as discussed above in connection with the selective deposition of the blocking oxide 20. The dielectric liner 101 may accordingly be deposited on the end surfaces 14a (see Fig. 2) of the etched back gate layers 14, or on a deposition-promoting layer 15 formed on the gate layers 14.

Fig. 11 shows the resulting lateral memory stack 119 after depositing the blocking oxide 20 on the dielectric liner 101, and then charge trap material 21.

Fig. 12 shows a lateral memory stack 219 according to yet a further variation wherein after depositing the blocking oxide 20 and prior to depositing the charge trap material 21, a (second) dielectric liner 102 (e.g. also of a high-k dielectric) has been selectively deposited on the blocking oxide 20 in the first recessed areas 18. The charge trap material 21 has then been selectively deposited on the dielectric liner 102. Each lateral memory stack 219 thus comprises a lateral stack of a blocking oxide 20, a dielectric liner 102 and a charge trap material 21.

In the above illustrated example methods, the first recessed areas 18 are formed prior to the second recessed areas 22. While this may confer an advantage of allowing an increased thermal budget for depositing the blocking oxide and the charge trap material, the opposite order is also possible, provided the thermal budget for the depositions of the blocking oxide and charge trap material is below the conversion temperature of the dummy material.

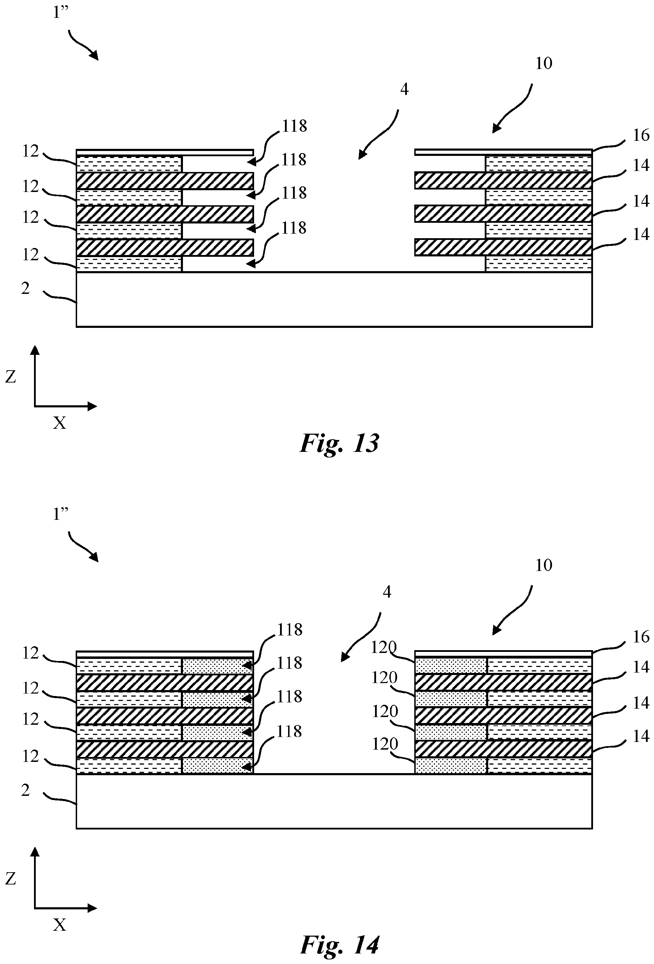

Fig. 13-16 shows a sequence of optional process steps for facilitating an area-selective deposition of the blocking oxide 20 and charge trap material 21. The process steps are intended to improve the deposition-inhibiting properties at the levels of the inter-gate spacer layers 12, thereby improving the area selectivity of the blocking oxide 20 and charge trap material 21.

Fig. 13 shows a structure 1" corresponding to the structure 1 wherein, prior to forming the first recessed areas 18, initial recessed areas 118 have been formed in a sidewall of the layer stack 10 surrounding the memory hole 4 by laterally etching back the inter-gate spacer layers 12 relative the gate layers 14 from the memory hole 4. The inter-gate spacer layers 12 are laterally etched back (along the X-axis) selectively to the gate layers 14 such that the initial recessed areas 118 are formed between the gate layers 14. That is, each recessed area / recess of the initial recessed areas 118 is formed between a pair of gate layers 14. Due to the circumferential extension of the sidewall about the memory hole 4, the initial recessed areas 118 may extend circumferentially about the memory hole 4. In the example of a circular memory hole 4, the initial recessed areas 118 may be annular.

The inter-gate spacer layers 12 may be etched back using an etching process adapted to etch the inter-gate spacer layers 12 selectively to the gate layers 14. That is, the etching process may be adapted to etch (i.e. remove) the material (e.g. the oxide material) of the inter-gate spacer layers 12 selectively to the material (e.g. the nitride material) of the gate layers 14, e.g. such that the inter-gate spacer layers 12 may be laterally etched back without causing any substantial etch-back of the gate layers 14. The etching process may be applied to the sidewall of the layer stack 10 via the memory hole 4. Any suitably selective etching process, wet or dry, providing a sufficient lateral etching component with respect to the inter-gate spacer layers 12 (such as an isotropic etching process) may be used.

The initial recessed areas 118 may be formed with a depth (along the X-axis) matching or exceeding an intended lateral thickness of at least the charge trap material 21 of the lateral memory stacks 19, optionally the intended lateral thickness of the full lateral memory stacks 19, to be formed at the levels of the gate layers 14. The depth (i.e. the amount of lateral etch back) of the initial recessed areas 118 may for example be in a range of 4-40 nm. The depth of the recessed areas 118 may be controlled by timing the lateral etch back.

In Fig. 14 sacrificial layers 120 have been formed in the initial recessed areas 118. The sacrificial layers 120 may as shown be formed to fill (i.e. re-fill) the initial recessed areas 118. The sidewall surrounding the memory hole 4 may thus be restored to a substantially straight profile. The sacrificial layers 120 define temporary deposition-inhibiting areas for a subsequent selective deposition of the blocking oxide and the charge trap material. The sacrificial layers 120 are thus formed of a sacrificial material selected to be deposition-inhibiting for subsequent selective deposition of blocking oxide and the charge trap material. The sacrificial material may further be selected as a material that can be etched selectively to the materials of the lateral memory stacks 19, so that the sacrificial layers 120 can be removed without removing the lateral memory stacks 19 at a later stage of the method. Example materials for the sacrificial layers 120 include metal oxide-layers, such as Al₂O₃ or TiO₂ layers, metal-nitride layers, such as AlN or TiN layers, metal layers, such as Co, Ru, Cu, W or Mo layers, or carbon-comprising layers, such as amorphous carbon or organic spin-on layers.

The sacrificial layers 120 may be formed by selectively depositing the sacrificial material to fill the initial recessed areas 118 using an ASD process, wherein the gate layers 14 define non-growth areas while the inter-gate spacer layers 12 growth areas with respect to the ASD process. The deposition of the sacrificial material may be continued until the initial recessed areas 118 are filled with the sacrificial material and the inner end surfaces of the sacrificial layers 120 are substantially flush with the inner end surfaces of the gate layers 14. Alternatively, forming the sacrificial layers 120 may comprise conformally depositing sacrificial material (e.g. by ALD) to fill the initial recessed areas 118 and cover the sidewall of the memory hole 4. The sacrificial material layer may subsequently be etched back (e.g. using an isotropic etch) to expose the inner end surfaces of the gate layers 14 at the sidewall of the memory hole 4.

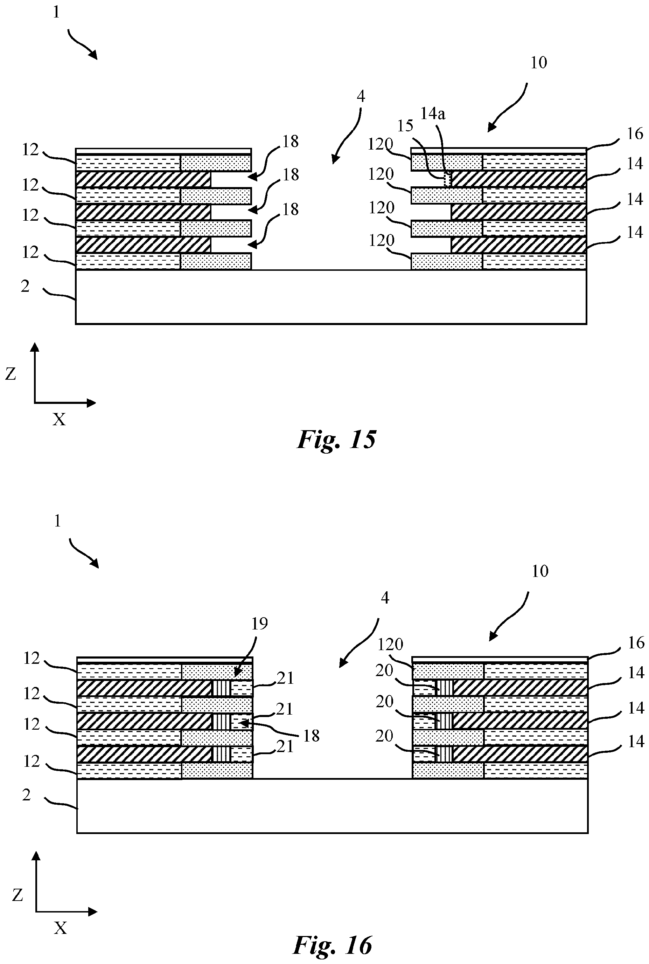

In Fig. 15, the first recessed areas 18 have been formed in the sidewall surrounding the memory hole 4 by laterally etching back the gate layers 14 relative the sacrificial layers 120 from the memory hole 4. The discussion of forming the first recessed areas 18 of the structure 1 in connection with Fig. 2 applies correspondingly to the structure 1" and Fig. 15 with the difference that the gate layers 14 here rather may be etched back using an etching process adapted to etch the gate layers 14 selectively to the sacrificial layers 120. That is, the etching process may be adapted to etch (i.e. remove) the material (e.g. the nitride material) of the gate layers 14 selectively to the sacrificial material of the sacrificial layers 120, e.g. such that the gate layers 14 may be laterally etched back without causing any substantial etch-back of the sacrificial layers 120. The etching process may be applied to the sidewall of the layer stack 10 via the memory hole 4. Any suitably selective etching process, wet or dry, providing a sufficient lateral etching component with respect to the gate layers 14 (such as an isotropic etching process) may be used.

By forming the first recessed areas 18 with a smaller lateral depth than the initial recessed areas 118, the inter-gate spacer layers 12 may be masked during the etch back of the gate layers 14, e.g. since the inter-gate spacer layers 12 then may be masked by the sacrificial layers 120 and the (etched-back) gate layers 14. If this is not the case, the etching process used to etch back the gate layers 14 may advantageously be adapted to etch the material (e.g. the nitride material) of the gate layers 14 selectively to both the sacrificial material of the sacrificial layers 120 and the material (e.g. oxide) of the inter-gate spacer layers 12.

The method may then proceed as shown in Fig. 16 by forming the lateral memory stacks 19 in each first recessed area 18 by selectively depositing, in the first recessed areas 18, the blocking oxide 20 and, subsequently, the charge trap material 21. Hence, both the blocking oxide 20 and the charge trap material 21 may be selectively deposited, wherein the sacrificial layers 120 define deposition-inhibiting areas (non-growth areas) for the selective deposition of the blocking oxide 20 and the charge trap material 21.

The blocking oxide 20 may be deposited using any deposition process (e.g. an ALD process) allowing area-selective deposition of the blocking oxide 20 (e.g. SiO₂) such that the blocking oxide 20 is deposited on growth-promoting or seeding surface portions in the first recessed areas 18 (e.g. the end surfaces of the etched back gate layers exposed in the first recessed areas 18) but not on the growth-inhibiting areas defined by the sacrificial layers 120. Correspondingly, the charge trap material 21 may be deposited using any deposition process (e.g. an ALD process) allowing area-selective deposition of the charge trap material 21 (e.g. SiN) such that the charge trap material 21 is deposited on growth-promoting or seeding surface portions in the first recessed areas 18 (e.g. the already deposited blocking oxide 20) but not on the growth-inhibiting areas defined by the sacrificial layers 120.

The above discussion of the possibility of applying a treatment step prior to depositing the blocking oxide 20, adapted to functionalize the end surfaces 14a of the etched back gate layers 14 and thereafter depositing the blocking oxide 20, and/or to passivate exposed surface portions of the inter-gate spacer layers 12, applies correspondingly to the structure 1" and the sacrificial layers 120. For instance, a treatment process may be adapted to increase an occurrence of hydrogen terminated bonds on the gate layers 14 (thus promoting deposition thereon) and/or reduce an occurrence of hydrogen terminated bonds on the sacrificial layers 120 (thus inhibiting deposition thereon). This is however merely one non-limiting example and other techniques are known to the skilled person.

As an illustrative example, the gate layers 14 may be SiN layers and the sacrificial layers 20 may be Al₂O₃ layers, wherein a blocking oxide 20 of SiO₂ may be selectively deposited using a plasma-enhanced ALD (PEALD) process comprising repeatedly performing a deposition cycle of: A) passivation of the sacrificial layers 120 using acetylacetone, B) introducing a Si precursor Bis(diethylamino)silane (BDEAS), and C) providing an O₂ plasma as co-reactant. The acetylacetone will cause grafting of the surface of the Al₂O₃ thus making the surface of the sacrificial layers 120 (but not the SiN of the gate layers 14) relatively inert to the Si precursor, such that the SiO₂ blocking oxide is selectively deposited in the first recessed areas 18. Selective deposition of charge trap material 21 of SiN may be achieved in a corresponding fashion, i.e. using a PEALD process comprising repeatedly performing a deposition cycle of A) passivation of the sacrificial layers 120, B) introducing a Si precursor, and C) providing an N₂ or NH₃ plasma. Various variations of these approaches are contemplated. For instance, the sacrificial layers 120 may be formed of another metal oxide, such as TiO₂. Passivation of sacrificial layers 120 may be achieved using an organic carboxylic acid such as pivalic acid, butyric acid, or the like. Instead of BDEAS some other relatively bulky Si precursor may be used. Furthermore, a thermal ALD process may be used instead of a PEALD process.

After forming the lateral memory stacks 19, the method may proceed by removing the sacrificial layers 120 employing a selective etch, etching the sacrificial material selectively to the charge trap material 21 and the blocking oxide 20. Any suitably selective etching process, wet or dry, providing a sufficient lateral etching component with respect to the sacrificial layers 120 (such as an isotropic etching process) may be used. By removing the sacrificial layers 120, the initial recessed areas 118 may be restored or re-opened.

Subsequently, the inter-gate spacer layers 12 may be re-grown in the restored initial recessed areas 118. The lateral memory stacks 21 (comprising the blocking oxide 20 and the charge trap material 21) in the first recessed areas 18 are thus vertically separated by the re-grown inter-gate spacer layers 12, corresponding to the structure 1 as shown in Fig. 3. The inter-gate spacer layers 12 may be re-grown by depositing the oxide material (e.g. SiO₂) of the inter-gate spacer layers 12, e.g. using a conformal deposition process such as ALD. Both area-selective and non-area selective deposition techniques are possible. For example, a selective oxide-on-oxide deposition process may be used to re-deposit the oxide material on the inter-gate spacer layers 12. Using a non-area selective deposition technique the oxide material may be conformally deposited to fill the initial recessed areas 18 and cover the sidewall (e.g. including the charge trap material 21) of the memory hole 4, and subsequently be laterally etched back to expose the inner end surfaces of the charge trap material 21 at the sidewall of the memory hole 4. The structure 1" may then be further processed as discussed with reference to Fig. 4 and onwards.

According to an example variation of the preceding flow, instead of re-growing the inter-gate spacer layers 12, the method may after removing the sacrificial layers 120 directly proceed with forming dummy layers 24 in the initial recessed areas 118. The initial recessed areas 118 may accordingly in this example define the second recessed areas 22 shown and discussed in relation Fig. 4-6.

According to yet another example variation, provided the sacrificial layers 120 are formed of any one of the example dummy materials for the dummy layer 18, the sacrificial layers 120 need not be removed after forming the lateral memory stacks 19, but rather remain in the structure 1" to define the dummy layers 18 which, after lining the sidewall of the memory hole 4 with liner layer 26 may be converted into air gap structures 28. This approach may be applied provided the dummy material (e.g. polymer-comprising) provides the desired deposition-inhibiting properties during deposition of the blocking oxide 20 and the charge trap material 21.

The person skilled in the art realizes that the present invention by no means is limited to the embodiments described above. On the contrary, many modifications and variations are possible within the scope of the appended claims.

## Claims

1. A method for forming a memory structure for a 3D NAND flash memory, the method comprising:
forming a layer stack (10) over a substrate (2), the layer stack (10) comprising an alternating sequence of gate layers (14) and inter-gate spacer layers (12);
forming first recessed areas (18) in a sidewall surrounding a memory hole (4) in the layer stack (10) by laterally etching back the gate layers (14) from the memory hole (4);
forming a lateral memory stack (19) in each first recessed areas (18), by depositing a blocking oxide (20) and, subsequently, a charge trap material (21);
forming second recessed areas (22) in the sidewall by laterally etching back the inter-gate spacer layers (12) from the memory hole (4);
forming dummy layers (24) in the second recessed areas (22);
after forming the lateral memory stacks (19) and the dummy layers (24), lining the sidewall of the memory hole (4) with a liner layer (26);
after lining the sidewall, subjecting the dummy layers (24) to a thermal treatment process adapted to convert each dummy layer (24) into an air gap structure (28), wherein the air gap structures (28) are formed laterally between the liner layer (26) and the inter-gate spacer layers (12);
forming a tunneling oxide layer (32) in the memory hole (4), along the liner layer (24); and
forming a channel layer (34) along the tunneling oxide layer (32).

2. The method according to claim 1, wherein the dummy layers (24) are formed of a polymer-comprising material.

3. The method according to claim 2, wherein the treatment process removes the polymer-comprising material of the dummy layers (24) from the second recessed areas (22), wherein, optionally, trace amounts of material of the dummy layers (24) remain in the second recessed areas to form the air gap structures (28).

4. The method according to any one of the preceding claims, wherein the liner layer (26) is deposited at a temperature below a temperature causing conversion of the dummy layers (24) into the air gap structures (28).

5. The method according to claim 4, wherein the liner layer (26) is formed of a low thermal oxide.

6. The method according to any one of claims 4-5, wherein a thickness of the liner layer (26) is in a range of 1-4 nm, or 1-2 nm.

7. The method according to any one of the preceding claims, wherein a lateral depth of the second recessed areas (22) is such that the air gap structures (28) undercut at least the charge trap material (21) of the lateral memory stacks (19).

8. The method according to claim 7, wherein the lateral depth of the second recessed areas (22) is such that the air gap structures (28) further undercut the blocking oxide (20) of the lateral memory stacks (19).

9. The method according to any one of the preceding claims, wherein the gate layers (14) are sacrificial gate layers and the method further comprises, subsequent to forming the air gap structures (18), replacing the sacrificial gate layers (14) by a replacement metal gate stack (34).

10. The method according to claim 9, wherein a lateral depth of the second recessed areas (22) is such that the air gap structures (28) undercut the charge trap material (21) of the lateral memory stacks (19) but do not undercut the blocking oxide (20) of the lateral memory stacks (21).

11. The method according to claim 11, further comprising depositing a further liner layer of a dielectric material in the second recessed areas (22) prior to forming the dummy layers (24), wherein the further liner layer (23) is used as an etch stop layer when replacing the sacrificial gate layers (14) by the replacement metal gate stack (36).

12. The method according to any one of the preceding claims, further comprising, prior to forming the first recessed areas (18):
forming initial recessed areas (118) in the sidewall surrounding the memory hole (4) by laterally etching back the inter-gate spacer layers (12) from the memory hole (4); and forming sacrificial layers (120) in the initial recessed areas (118);
wherein the first recessed areas (18) are formed after forming the sacrificial layers (120), and wherein the lateral memory stacks (19) are formed by selectively depositing, in the first recessed areas (18), the blocking oxide (20) and, subsequently, the charge trap material (21), wherein the sacrificial layers (120) define deposition-inhibiting areas for the selective deposition of the blocking oxide (20) and the charge trap material (21).

13. The method according to claim 12,
wherein the initial recessed areas (118) are the second recessed areas (22) and the method further comprises, after forming the lateral memory stacks (19), removing the sacrificial layers (120) from the second recessed areas (22) by etching from the memory hole (4) and thereafter forming the dummy layers (24) in the second recessed areas (22); or
wherein the method further comprises, after forming the lateral memory stacks (19):
removing the sacrificial layers (120) by etching from the memory hole (4);
after removing the sacrificial layers (120), re-growing the inter-gate spacer layers (12) such that the lateral memory stacks (19) are vertically separated by the re-grown inter-gate spacer layers (12);
and wherein after re-growing the inter-gate spacer layers (12), the method proceeds by forming the second recessed areas (22) by laterally etching back the re-grown inter-gate spacer layers (12).

14. The method according to claim 13, wherein the sacrificial layers (120) are metal oxide-layers, such as Al₂O₃ or TiO₂ layers, metal-nitride layers, such as AlN or TiN layers, metal layers, such as Co, Ru, Cu, W or Mo layers, or carbon-comprising layers, such as amorphous carbon or organic spin-on layers.

15. The method according to claim 12, wherein the initial recessed areas (118) are the second recessed areas (22) and the sacrificial layers (120) are the dummy layers (24).
